Europäisches Patentamt

European Patent Office

Office européen des brevets

(11) Veröffentlichungsnummer: **0 337 204 B1**

# (12) EUROPÄISCHE PATENTSCHRIFT

(45) Veröffentlichungstag der Patentschrift:
28.08.91 Patentblatt 91/35

(51) Int. Cl.$^5$: **G01R 33/36**

(21) Anmeldenummer: 89105646.7

(22) Anmeldetag: 30.03.89

(54) **Anordnung zum Betrieb einer symmetrischen Hochfrequenz-Antenne.**

(30) Priorität: 11.04.88 DE 3811983

(43) Veröffentlichungstag der Anmeldung:
18.10.89 Patentblatt 89/42

(45) Bekanntmachung des Hinweises auf die
Patenterteilung:
28.08.91 Patentblatt 91/35

(84) Benannte Vertragsstaaten:
DE FR GB

(56) Entgegenhaltungen:
GB-A- 2 161 940
US-A- 4 028 704
US-A- 4 031 540
US-A- 4 631 504

(56) Entgegenhaltungen:
US-A- 4 682 125
PATENT ABSTRACTS OF JAPAN, Band 10, Nr.
91 (E-394)[2148], 9. April 1986, Seite 142 E 394
& JP-A-60-235 530
DL-QTC, Nr. 4, April 1961, Seiten 156-158, W.
Körner-Verlag, Stuttgart, DE; R. AUERBACH:
"Coax-Speisung symmetrischer Antennen"

(73) Patentinhaber: Siemens Aktiengesellschaft
Wittelsbacherplatz 2
W-8000 München 2 (DE)

(72) Erfinder: Dürr, Wilhelm, Dr.
Damaschkestrasse 99
W-8520 Erlangen (DE)
Erfinder: Oppelt, Ralph, Dr.
Lindenweg 1
W-8525 Weiher (DE)

EP 0 337 204 B1

**Beschreibung**

Die Erfindung bezieht sich auf eine Anordnung zum Betrieb einer symmetrischen Hochfrequenz-Antenne, insbesondere der Hochfrequenz-Antenne eines Kernspintomographen, die an eine unsymmetrische Leitung angeschlossen ist und bei der zwischen der Hochfrequenzantenne und der Leitung eine Mantelwellensperre vorgesehen ist.

Es sind Geräte zum Erzeugen von Schnittbildern eines Untersuchungsobjektes, vorzugsweise eines menschlichen Körpers, mit magnetischer Kernresonanz bekannt. Diese sogenannten Kernspintomographen enthalten einen Grundfeld-Magneten, der die Kernspins im menschlichen Körper ausrichtet, und ferner Gradientenspulen, die ein räumlich unterschiedliches Magnetfeld erzeugen, und schließlich Hochfrequenz-Antennen zur Anregung der Kernspins und zum Empfang der von den angeregten Kernspins emittierten Signale. Beim Einsatz einer derartigen hochfrequenten Anregungs- und Meßspule wird die Induktivität der Spule zusammen mit einer veränderbaren Kapazität als LC-Resonanzkreis geschaltet, wobei dann die Kondensatoranordnung der gewünschten Frequenz entsprechend abgestimmt wird. Die Zuleitung enthält noch eine veränderbare Koppelkapazität zur Ankopplung des Resonators an einen Hochfrequenzgenerator, der vorzugsweise ein Oszillator mit einem nachgeschalteten Sendeverstärker sein kann.

Es ist bekannt, daß man Dipole, Richtstrahler und andere im Speisepunkt niederohmige Antennen mit Koaxialkabeln speisen kann. Sender sind im allgemeinen so ausgelegt, daß nur niederohmige, unsymmetrische Kabel angeschlossen werden können. Sollen symmetrische Verbraucher gespeist werden, so muß ein Symmetrierglied zwischengeschaltet werden, dessen genaue Abstimmung beim Frequenzwechsel häufig umständlich und zeitraubend ist. Koaxialkabel sind unsymmetrisch aufgebaut und da sie verlustarm praktisch nur niederohmig realisierbar sind, kommt für die Speisung von Antennen nur der Anschluß in einem Strombauch in Frage. Werden beispielsweise Innen- und Außenleiter des unsymmetrischen Koaxialkabels mit den beiden erdsymmetrischen Strahlerhälften verbunden, so ist die Summe des im Innen- und Außenleiter des Kabels hin- bzw. rücklaufenden Stromes verschieden von Null, weil dann beide Strahlerhälften keine völlig symmetrischen Eigenschaften gegenüber der Umgebung, beispielsweise gegen Erde, mehr aufweisen. Aufgrund dieser Stromdifferenz bildet sich somit zum Ausgleich eine Mantelwelle aus, deren Amplitude besonders hoch ist, wenn die Kabellänge mit der Wellenlänge der Mantelwelle in Resonanz ist. Zur Begrenzung der Verluste durch Beseitigung dieser Mantelwellen wird zwischen dem Antennenanschluß und dem Kabel eine sogenannte Mantelwellensperre eingebaut, die im wesentlichen aus einer Drossel besteht. Die beste Unterdrückung von Mantelwellen erhält man mit einer Doppeldrossel, die aus zwei Hälften einer zylinderförmigen Spule besteht. Zwischen den beiden Hälften ist die Antenne angeschlossen ("DL-QTC", W. Körner-Verlag Stuttgart 1961, Heft 4, Seiten 156-158).

Der Erfindung liegt nun die Aufgabe zugrunde, diese bekannte Ausführungsform einer Mantelwellensperre zu vereinfachen und zu verbessern.

Die Erfindung beruht auf der Erkenntnis, daß bei den bekannten Ausführungsformen der Mantelwellensperre eine Einkopplung des Feldes der Antenne in das Streufeld der Mantelwellensperre nicht ausgeschlossen werden kann. Die Erfindung besteht darin, daß die Induktivität der Mantelwellensperre als Toroid gestaltet ist und vorzugsweise aus einem Ringkern angeordnet sein kann. In dieser Ausführungsform der Mantelwellensperre hat sie praktisch kein Streufeld. Der Ringkern kann aus Kunststoff und in einer bevorzugten Ausführungsform auch aus hochpermeablem Material bestehen.

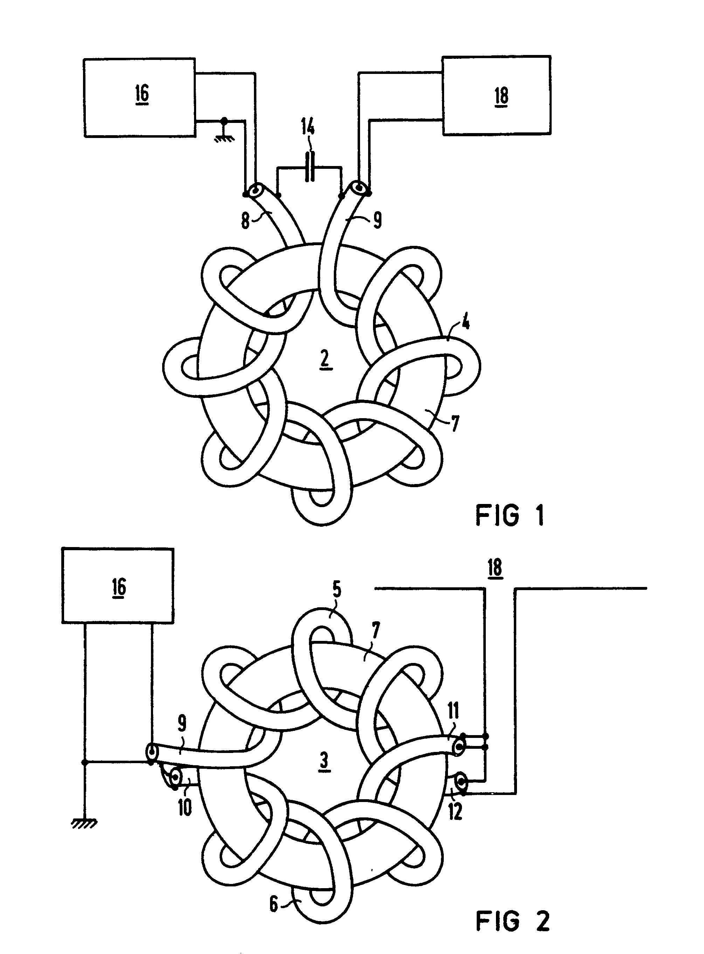

Zur weiteren Erläuterung der Erfindung wird auf die Zeichnung Bezug genommen, in deren Figuren 1 und 2 jeweils ein Ausführungsbeispiel einer Mantelwellensperre gemäß der Erfindung schematisch veranschaulicht ist.

In der Ausführungsform gemäß Figur 1 besteht eine Mantelwellensperre 2 aus einem Koaxialkabel 4, das als Toroid gewickelt und auf einem Ringkern 7 angeordnet ist. Die Enden 8 und 9 des Außenmantels des Koaxialkabels 4 sind über einen Kondensator 14 miteinander verbunden und bilden mit der Induktivität des Koaxialkabels 4 einen Parallelschwingkreis. Der Innenleiter des Kabelendes 8 ist an eine Quelle, beispielsweise einen Sender 16, angeschlossen. Der Außenmantel des Kabelendes 8 ist ebenfalls mit dem Sender 16 verbunden und an Masse gelegt. An das zweite Kabelende 8 ist eine symmetrische Last, beispielsweise eine Dipolantenne 18, insbesondere die Hochfrequenz-Antenne eines Kernspintomographen mit einer Betriebsfrequenz von beispielsweise 42 MHz, angeschlossen.

Im Sendefall speist somit der unsymmetrische Sender 16 eine symmetrische Last. Durch die Resonanzbedingung stellt die Mantelwellensperre 2 einen hochohmigen Widerstand dar, der Mantelwellen von der Dipolantenne 18 vom Sender 16 entkoppelt. Im Empfangsfall wirkt die Antenne 18 als symmetrische Quelle und überträgt das aufgenommene Hochfrequenzsignal auf einen Empfänger, der als unsymmetrische Last wirkt, wobei auch hier keine Mantelwellen von der Quelle zur Last passieren können. In beiden Fällen wirkt die Mantelwellensperre 2 zugleich als Symmetrierglied, bei dem eine Kopplung des Feldes der Dipolantenne 18 mit dem Streufeld der Mantelwellensperre 2 praktisch ausgeschlossen ist.

Unter Umständen kann es zweckmäßig sein, in der Ausführungsform gemäß Figur 1 keine Kapazität 14 zwischen den Enden 8 und 9 einzuschalten. In dieser Ausführung wird dann die Windungszahl W des Koaxialkabels 4 und die relative Permeabilität $\mu_r$ des Kerns 7 so gewählt, daß bei gegebener Betriebsfrequenz $\omega$ die Induktivität

$$L \gg Z/\omega$$

ist, wobei Z der Wellenwiderstand des Kabels 4 ist. Damit erhält man eine breitbandige Mantelwellensperre.

In der besonderen Ausführungsform einer Mantelwellensperre 3 gemäß Figur 2 als Doppeldrossel sind zwei Koaxialkabel 5 und 6 auf den Ringkern 7 aufgewickelt. An ihre Enden 9 und 10 ist als Quelle der Sender 16 und an die anderen Enden 11 und 12 sind als Last die beiden nicht näher bezeichneten Strahlerhälften der Dipolantenne 18 angeschlossen. Die linke Strahlerhälfte ist mit dem Mantel des einen Endes 11 und den beiden Innenleitern verbunden. Die andere Strahlerhälfte ist an den Mantel des anderen Kabelendes 12 angeschlossen. Die beiden Koaxialkabel 5 und 6 mit gleicher Windungszahl, gleichen Leiterlängen und gleichem Wellenwiderstand sind auf der Senderseite beide mit dem Sender 16 verbunden. Die beiden Mäntel der Enden 9 und 10 sowie der Innenleiter des Endes 10 sind miteinander und mit dem Sender 16 verbunden und an Masse gelegt. Der Innenleiter des Endes 9 ist an den Sender 16 angeschlossen.

## Patentansprüche

1. Anordnung zum Betrieb einer symmetrischen Hochfrequenz-Antenne (18), insbesondere der Hochfrequenz-Antenne (18) eines Kernspintomographen, die an eine unsymmetrische Leitung angeschlossen ist und bei der zwischen der Hochfrequenz-Antenne (18) und der Leitung eine Mantelwellensperre (2) vorgesehen ist, **dadurch gekennzeichnet, daß die Induktivität L der Mantelwellensperre (2) als Toroid gestaltet ist.**

2. Anordnung nach Anspruch 1, **dadurch gekennzeichnet, daß die Induktivität L auf einem Ringkern (7) angeordnet ist.**

3. Anordnung nach Anspruch 2, **dadurch gekennzeichnet, daß ein Ringkern (7) aus hochpermeablem Material vorgesehen ist.**

4. Anordnung nach einem der Ansprüche 1 bis 3, **gekennzeichnet** durch eine Mantelwellensperre (3) als Doppeldrossel mit zwei Koaxialkabeln (5, 6) gleicher Leitungslänge, gleicher Windungszahl und gleichen Wellenwiderstandes, die auf den gemeinsamen Ringkern (7) aufgewickelt sind und zwischen denen die Hälften der Antenne (18) angeschlossen sind.

## Claims

1. An arrangement for operating a symmetrical high-frequency antenna (18), in particular the high-frequency antenna (18) of a nuclear magnetic resonance tomograph, which arrangement is connected to an asymmetrical line and in which there is provided, between the high-frequency antenna (18) and the line, a sheath wave trap (2), characterised in that the inductor L of the sheath wave trap (2) is in the shape of a toroid.

2. An arrangement according to claim 1, characterised in that the inductor L is arranged on a toroidal core (7).

3. An arrangement according to claim 2, characterised in that a toroidal core (7) of highly permeable material is provided.

4. An arrangement according to one of claims 1 to 3, characterised by a sheath wave trap (3) serving as a double inductor having two coaxial cables (5, 6) of the same line length, of an equal number of turns and of the same characteristic impedance, which are wound around the common toroidal core (7) and between which the halves of the antenna (18) are connected.

## Revendications

1. Dispositif pour exploiter une antenne symétrique à haute fréquence (18), notamment l'antenne à haute fréquence (18) d'un tomographe à résonance magnétique nucléaire, et qui est raccordé à une ligne dissymétrique et dans lequel l'unité (2) de blocage des ondes enveloppes est prévue entre l'antenne à haute fréquence (18) et la ligne, caractérisé par le fait que l'inductance (L) de l'unité (2) de blocage des ondes enveloppes est réalisée sous la forme d'un tore.

2. Dispositif suivant la revendication 1, caractérisé par le fait que l'inductance L est montée sur un noyau annulaire (7).

3. Dispositif selon la revendication 2, caractérisé en ce qu'il est prévu un noyau annulaire (7) réalisé en un matériau possédant une haute perméabilité.

4. Dispositif selon l'une des revendications 1 à 3, caractérisé par une unité (3) de blocage des ondes enveloppes réalisée sous la forme d'une bobine d'arrêt double comportant deux câbles coaxiaux (5, 6) possédant une même longueur, un même nombre de spires et une même impédance caractéristique et qui sont enroulés sur le noyau annulaire commun (7) et entre lesquels sont branchés les moitiés de l'antenne (18).

FIG 1

FIG 2